# EUROPEAN PATENT SPECIFICATION

(11) **EP 1 408 725 B1**
(45) Date of publication and mention of the grant of the patent: **12.12.2007**
(21) Application number: 02022803.7
(22) Date of filing: 11.10.2002
(51) Int. Cl.: H05K 3/06, H05K 3/38, H05K 3/26, H01L 21/48

(54) **Process for producing ceramic circuit boards**
Verfahren zur Herstellung von keramischen Leiterplatten
Procédé de fabrication de panneaux à circuit céramiques

(43) Date of publication of application: 14.04.2004
(73) Proprietor: DOWA METALTECH CO., LTD., Chiyoda-ku Tokyo 101-0021 (JP)
(72) Inventor: Sakuraba, Masami, Chiyoda-ku, Tokyo (JP); Kimura, Masami, Chiyoda-ku, Tokyo (JP); Ono, Takashi, Chiyoda-ku, Tokyo (JP); Ishii, Noriyuki, Chiyoda-ku, Tokyo (JP); Tukaguchi, Nobuyoshi, Chiyoda-ku, Tokyo (JP)
(74) Representative: Strehl Schübel-Hopf & Partner

(56) References cited:
- EP-A- 0 798 779
- US-A- 5 354 415
- PATENT ABSTRACTS OF JAPAN vol. 2000, no. 22, 9 March 2001 (2001-03-09) -& JP 2001 135929 A (DOWA MINING CO LTD), 18 May 2001 (2001-05-18)
- PATENT ABSTRACTS OF JAPAN vol. 1998, no. 11, 30 September 1998 (1998-09-30) & JP 10 154866 A (SUMITOMO KINZOKU ELECTRO DEVICE:KK), 9 June 1998 (1998-06-09)

## Description

### BACKGROUND OF THE INVENTION

This invention relates to a ceramic circuit board and a module that has a circuit formed after joining a metal sheet to a ceramic substrate with the intermediary of a brazing material and which is suitable for mounting of high power devices such as a power module, as well as a module that uses the ceramic circuit board. The invention particularly relates to a method for removing unwanted brazing material and the like that remain between metallic circuit patterns or on edges or the like after etching the metal sheet and which are deleterious to the insulation on the ceramic circuit board.

The first step in the production of ceramic circuit boards suitable for making power modules and mounting semiconductor devices is joining a metal sheet to a ceramic substrate. This step is industrially practiced by two major approaches, direct joining and brazing. In the direct joining method, a copper sheet is placed in direct contact with a ceramic substrate and the two members are heated in an inert gas to be joined together. In the brazing method, a copper sheet is placed on a ceramic substrate with the intermediary of a brazing material containing an active metal such as Ti, Zr or Hf and the two members are heated in vacuum to be joined together. In the latter method, the active metal participates in the joining of the metal sheet to the ceramic substrate and the brazing material forms a reaction product with the ceramic substrate. It is generally said that the brazing material provides a joint by forming an oxide of the active metal if the substrate is made of an oxide ceramic such as Al₂O₃ and a nitride of the active metal if the substrate is made of a non-oxide ceramic such as AlN or Si₃N₄

After joining a metal sheet such as copper sheet for the dual purpose of circuit formation and heat dissipation, patterning is effected to make a predetermined circuit shape. To this end, etching which is a common technique in the fabrication of printed circuit boards is extensively used since fine patterns are easy to form and it is comparatively simple to adapt for a change in circuit design. As a liquid etchant for metal sheets such as a copper sheet, a solution of a mixture of iron chloride or copper chloride, hydrochloric acid and aqueous hydrogen peroxide is commonly used. In the direct copper joining method described above, the reaction product is negligible and the result of etching and patterning is completely satisfactory.

In the brazing method, the copper sheet dissolves but this is not the case with the brazing material and the product of reaction between the brazing material and the ceramic substrate (the brazing material and the reaction product are hereunder collectively referred to as the "brazing material and the like") and they will remain between circuit patterns or on edge faces of the substrate. Since the brazing material and the like are a conductor, they are incapable of satisfying the basic requirement of the circuit board, i.e., providing isolation between circuit patterns or across the substrate. Two methods are known to be capable of removing the brazing material and the like: one method depends on treatment with (1) hydrofluoric acid alone, (2) a mixture of hydrofluoric acid and at least one other inorganic acid selected from among nitric acid, sulfuric acid and hydrochloric acid, (3) aqua regia or (4) a solution of sodium hydroxide and/or potassium hydroxide (Japanese Patent No. 2594475); the other method involves treatment first with an aqueous solution containing a hydrogen halide and/or an ammonium halide, then with an aqueous solution containing an inorganic acid and aqueous hydrogen peroxide.

These prior art methods for removing the brazing material and the like from ceramic circuit boards have the following problems.
(1) If liquid chemicals containing a hydrogen fluoride or an ammonium halide typified by hydrofluoric acid, its mixture with another inorganic acid, or ammonium fluoride are used, not only the brazing material and the like but also the ceramic substrate is corroded, often leading to deterioration in the reliability characteristics of the ceramic circuit board. If an attempt is made to suppress the corrosion of the ceramic substrate, the brazing material and the like between circuit patterns cannot be completely removed but remain partially.
(2) Since halogen compounds such as hydrofluoric acid are highly corrosive, production equipment, liquid waste treatment facilities, as well as various operations including the treatment of liquid wastes are expensive and the production cost tends to increase.
(3) Liquid chemicals including nitric acid corrode not only the brazing material and the like but also the circuit forming metal sheet such as Cu sheet, leading to inaccuracy in the shape, dimensional precision and other factors of the circuit pattern.
(4) Depending on the type and thickness of the brazing material and the type of liquid chemicals used, control and handling difficulties are encountered as exemplified by the failure of the brazing material and the like to dissolve and the need to perform treatments for a prolonged period or at elevated temperature.

Therefore, the following were the goals to be attained by the inventors of the present invention:
(1) ensuring that the corrosion of the ceramic substrate by liquid chemicals is held to a minimum level that will not affect the characteristics of the ceramic circuit board;
(2) simplifying liquid waste treatment facilities and other equipment as well as various treatment;
(3) suppressing the corrosion of the metal circuit forming sheet to an insignificant level;
(4) reducing the cost of liquid chemicals; and
(5) ensuring easy control and handling of liquid chemicals while enabling mass production of the final product.

### SUMMARY OF THE INVENTION

With a view to attaining these goals, the present inventors made intensive studies and found a liquid chemical that met the following requirements:
(1) only limited corrosion of the ceramic substrate;
(2) simple handling and treatment as in liquid waste treatment;
(3) no extensive corrosion of the metal circuit forming sheet;
(4) low cost and recyclability;
(5) easy control and handling of the liquid chemical and which was capable of selective removal of the unwanted brazing material and the like that remained after etching on the ceramic circuit board. The present invention has been accomplished by using the liquid chemical under appropriate conditions.

Thus, the present invention provides the following:
(1) A process for producing a ceramic circuit board comprising the steps of joining a metal sheet to at least one side of a ceramic substrate with the intermediary of a brazing material, etching said metal sheet to a circuit pattern and then applying a liquid chemical containing a chelating reagent and aqueous hydrogen peroxide or a liquid chemical containing a chelating reagent, aqueous hydrogen peroxide and an alkali to remove said brazing material and the reaction product between the brazing material and the ceramic substrate that have become exposed as the result of said etching.
(2) The process according to (1), wherein after removing said brazing material and the reaction product between the brazing material and the ceramic substrate, a Ni plating or a Ni alloy plating is applied to said metal sheet.
(3) The process according to (1) or (2), wherein said chelating reagent is at least one compound selected from the group consisting of EDTA, NTA, CyDTA, DTPA, TTHA, GEDTA and salts thereof.
(4) The process according to any one of (1) - (3), wherein said alkali is at least one compound selected from the group consisting of ammonia, NaOH and KOH.
(5) The process according to any one of (1) - (4), wherein said brazing material is one which contains Ag and an active metallic element.
(6) The process according to any one of (1) - (5), wherein said ceramic substrate is one which comprises Al₂O₃, AlN or Si₃N₄ as a main component.
(7) The process according to any one of (1) - (6), wherein said liquid chemical has a temperature of 40 °C or less when said brazing material and the reaction product between the brazing material and the ceramic substrate are being removed.
(8) A ceramic circuit board for use in making a power module which is produced by the process according to any one of claims (1) - (7).
(9) A module using a ceramic circuit board produced by the process according to any one of (1) - (7).

### BRIEF DESCRIPTION OF THE DRAWINGS

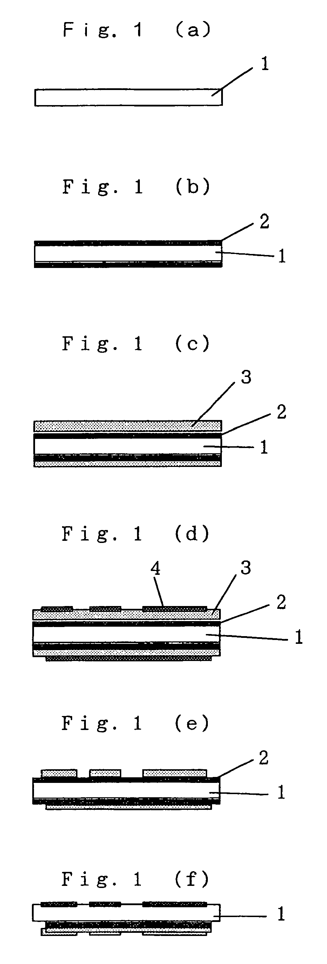

Figs. 1A - 1F illustrate the sequence of steps in an example of the manufacturing process of the invention, wherein
Fig. 1A is a schematic cross section of a ceramic substrate;
Fig. 1B is a schematic cross section of the ceramic substrate with a brazing material printed to both sides;
Fig. 1C is a schematic cross section of the ceramic substrate with a metal sheet joined to the brazing material on both sides;
Fig. 1D is a schematic cross section of the ceramic substrate with a resist printed to the metal sheet on both sides;
Fig. 1E is a schematic cross section of the ceramic substrate with the resist being removed after etching the metal sheet on the both sides; and
Fig. 1F is a schematic cross section of the ceramic substrate on which a circuit pattern has been formed by removing the unwanted brazing material and the like that remained after removing the resist.

### DETAILED DESCRIPTION OF THE INVENTION

The liquid chemical used in the invention in order to dissolve away the brazing material and the like has adequate dissolving power at room temperature and thereabouts and hence permits easy control of temperature. If it is desired to dissolve the brazing material and the like at faster rate, the liquid chemical may be heated to an extent that will not cause a violent dissolving reaction to occur. The liquid chemical may be applied by spraying or dipping. The liquid chemical causes only limited damage to the ceramic substrate and, hence, assures greater reliability than when acid mixtures of hydrofluoric acid or hydrogen halides are used.

If the concentrations of the chelating reagent, aqueous hydrogen peroxide and alkali are unduly low, the dissolving rate and solubility of the brazing material and the like lower to increase their chance of remaining undissolved. In order to avoid this problem, the treatment needs to be prolonged or the amount of the liquid chemical must be increased to an extreme level; however, these approaches are not preferred from an industrial viewpoint. If the concentration of the chelating reagent is unduly high, the solubility is so much reduced that it will remain undissolved. If the concentrations of aqueous hydrogen peroxide and alkali are unduly high, there is high likelihood that bumping of the liquid chemical occurs as an abnormal reaction. Therefore, the respective concentrations of the chelating reagent, aqueous hydrogen peroxide and alkali have suitable ranges in industrial applications and the preferred range is from 1 to 3 wt% for the chelating reagent, from 5 to 25 wt% for aqueous ammonia which is used as an alkali, and from 5 to 20 wt% for aqueous hydrogen peroxide.

Inexpensive EDTA is preferred as the chelating reagent. If no alkali is added to the liquid chemical, low pH results and the solubility of the chelating reagent decreases. This either prolongs the time required to remove the brazing material and the like or increases their chance to remain undissolved. In order to avoid these problems, the liquid chemical is preferably held alkaline. This is also true with a solution of a 4 Na salt of EDTA (its aqueous solution is alkaline) since the pH decreases with the progress of the brazing material and the like; in this case, the alkali also serves as a buffer.

In order to ensure that the liquid chemical is easy to control and handle in industrial applications, it is preferably controlled at a temperature of 40 °C or below, more preferably at 30 °C or below. Beyond 40 °C, the liquid chemical of the contemplated system will "bump" if it has large quantities of the brazing material and the like dissolved therein and this is on account of the resulting heat of reaction. The thus prepared liquid chemical is difficult to handle and hazardous and is not suitable for treating large quantities of products on an industrial scale. On the other hand, by reviewing the recipe of the liquid chemical which they found to be suitable for removing the brazing material and the like from ceramic circuit boards, as well as the need to control the temperature of the liquid chemical and the properties of the brazing material and the ceramic substrate, the present inventors have succeeded in providing a process for producing ceramic circuit boards that is easy and safe to operate, that allows for simple treatment of liquid wastes, that can be performed at low cost and which permits mass production on an industrial scale.

The brazing material used in the invention for joining the ceramic substrate and the metal sheet is based on Ag or Ag-Cu and contains besides at least one active metallic element or its compound selected from the group consisting of Ti, Zr and Hf as well as TiH₂ and ZrH₂. According to a currently practiced method, a Cu sheet or the like having good electrically conducting characteristics is chosen as the metal sheet and joined to the ceramic substrate, overlaid with a resist layer and etched to give a predetermined circuit pattern; after etching, the resist layer is removed. The brazing material and the like are then removed; since the Cu sheet and the like are also exposed to the surface, they will be extensively attacked by certain kinds of liquid chemical so that the circuit pattern is deformed or they become extremely thin. In the present invention, the brazing material based on Ag or Ag-Cu is preferred for the following reason: the liquid chemical of the invention can dissolve Ag in the brazing material and the like at an overwhelmingly higher speed than Cu and, in addition, it corrodes the Cu circuit forming sheet only a little as compared to the ingredients of the brazing material and the like. For this reason, the brazing material to be used in the invention preferably contains 65 - 99 wt% of Ag and 1 - 10 wt% of the active metal, with the balance being essentially Cu. The brazing material may be placed on the entire surface of the ceramic substrate or in preselected areas only, depending on use and other factors.

A copper (sometimes abbreviated as Cu) sheet having high heat and electrical conductivity is often used as the metal sheet. Since the liquid chemical does not contain nitric acid, the corrosion of the Cu circuit forming sheet is suppressed. In addition, as already mentioned, the liquid chemical of the invention dissolves the Ag based brazing material and the like at an overwhelmingly higher speed than Cu and, as a result, removal of the unwanted brazing material and the like will end before the corrosion of the Cu circuit forming sheet progresses to a no longer negligible extent.

The present invention has the added advantage of lower cost since the chelating reagent can be reclaimed or recovered from the liquid waste that forms after dissolving the brazing material and the like. To be more specific, the chelating reagent, say, EDTA dissolves only a little (about 0.2%) in water under strong acidic conditions, so in order to recover the chelating reagent, an acid such as sulfuric acid may be added to the liquid waste that forms after dissolving the brazing material and the like or, alternatively, the volume of the liquid waste is first reduced by, for example, evaporation and then an acid such as sulfuric acid is added (the acid to be added is preferably a nonvolatile and inexpensive acid such as sulfuric acid), whereupon the chelating reagent precipitates as a filterable mass.

In order to provide better weatherability while preventing time-dependent changes in other characteristics such as wettability with solder, the metal sheet which provides a circuit pattern on the surface of the ceramic circuit board is preferably plated with Ni or a Ni alloy. Plating may be performed either by an ordinary electroless technique which comprises degreasing, chemical polishing and a preliminary treatment with a Pd activating liquid chemical, followed by application of a hypophosphite containing liquid chemical as a Ni-P electroless plating solution or by a method in which electroplating is performed with an electrode being placed in contact with the circuit pattern.

Various ceramic substrates may be used in the invention, as exemplified by Al₂O₃ (hereunder sometimes called "alumina"), AlN and Si₃N₄; Al₂O₃ is inexpensive, AlN is expensive but a good heat conductor, and Si₃N₄ which is a moderate heat conductor ranked between Al₁O₃ and AlN is expensive but shows high strength and tenacity. The respective features of these ceramic substrates can be used to produce ceramic circuit boards of different characteristics: Al₂O₃ can provide an inexpensive ceramic circuit board; AlN takes advantages of its good heat dissipating property to provide a ceramic circuit board compatible with semiconductor devices such as high power chips that dissipate a large quantity of heat; Sl₃N₄, taking advantage of its high strength, may be used to provide a ceramic circuit board that has sufficiently high resistance to thermal impact and environment that it is suitable for use under hostile conditions as in an automobile.

After making the ceramic circuit board according to the present invention, a semiconductor chip, resistors and other electric and electronic components are soldered or otherwise mounted to the metal circuit forming sheet and a heat dissipating sheet is soldered or otherwise joined to the other side of the board; thereafter, a plastic case or the like is bonded to the assembly and external terminals are connected to the circuit board by ultrasonic wire bonding, followed by injection of insulating gel, bonding of an upper lid and any other necessary steps to complete a module for ready use.

The following examples are provided for the purpose of further illustrating the present invention but are in no way to be taken as limiting its technical scope.

### [Example 1]

Metal powders were weighed to give a 71Ag-27Cu-1.5Ti-0.5TiO₂ (wt%) formula, to which ca. 10% acrylic vehicle was added; the ingredients were kneaded by an ordinary method using a mortar and a pestle, a triple roll mill, etc. to make a paste of brazing material (on the following pages, the sequence of steps employed in Example 1 are described with reference to Fig. 1). The brazing material was screen printed to both sides of the ceramic substrate (Figs. 1A and 1B); a Cu sheet was then placed on both sides and joined to the brazing material in a vacuum furnace at 850 °C (Fig. 1C). Thereafter, a section of the sample was cut and the thickness of the brazing material and the like was measured; the result was 20 microns thick. The ceramic substrate was an AlN substrate of S grade manufactured by ATG, Inc. The sample was taken out of the vacuum furnace and resist ink was applied to the joined Cu sheet on both sides, with the resist on one side being formed in a desired circuit pattern (Fig. 1D). The unwanted areas of the Cu sheet were removed by treatment with a solution of a mixture of cupric chloride, hydrochloric acid and aqueous hydrogen peroxide and the resist pattern was removed by treatment with a liquid alkali to form a circuit (Fig. 1E). At this stage, the unwanted brazing material and the like remained undissolved between circuit patterns and on edge faces of the substrate and no necessary insulation was provided between circuit patterns and across the substrate.

In order to remove the unwanted brazing material and the like from between circuit patterns and from edge faces of the substrate, the assembly was dipped for 40 minutes in a solution of a mixture of EDTA, ammonia and aqueous hydrogen peroxide, recovered, washed with water and dried to provide a ceramic circuit board (Fig. 1F). Thereafter, Ni-P electroless plating was selectively applied to the surface of the metal sheet on both sides of the circuit board.

The conditions for the preparation of the sample and the results of evaluation of the circuit board obtained are shown in Table 1. The residual brazing material on the AlN substrate was found to have dissolved away completely with no indication of color change in the AlN substrate; the brazing material and the like had been sufficiently removed to cause no adverse effects on the electrical characteristics of the circuit board.

**Table 1**

| Conditions for sample preparation and the results of evaluation | | | | | | | | | | |
|---|---|---|---|---|---|---|---|---|---|---|
| Run | ceramic substrate | thickness of brazing material and the like (µm) like (µm) | Composition of liquid chemical and temperature at the time of start of treatment | | | | | removal of brazing material and the like | | line linearity |
| | | | EDTA (g/L) | aqueous ammonia (ml/L) | aqueous hydrogen peroxide (ml/L) | pure water (ml/L) | temperature (°C) | visual check | resistance (MΩ) | |
| Example 1 | AlN | 20 | 14.1 | 110 | 170 | 720 | 20°C | OK | ≧ 1000 | ○ |
| Example 2 | Al₂O₃ | 20 | 14.1 | 110 | 170 | 720 | 20°C | OK | ≧ 1000 | ○ |
| Example 3 | AlN | 10 | 14.1 | 110 | 170 | 720 | 20°C | OK | ≧ 1000 | ○ |
| Example 4 | AlN | 20 | 14.1 | 110 | 170 | 720 | 20°C | OK | ≧ 1000 | ○ |
| Example 5 | AlN | 50 | 14.1 | 110 | 170 | 720 | 20°C | OK | ≧ 1000 | ○ |
| Example 6 | AlN | 20 | 14.1 | 110 | 170 | 720 | 20°C | OK | ≧ 1000 | ○ |
| Example 7 | Al₂O₃ | 20 | 14.1 | 110 | 170 | 720 | 20°C | OK | ≧ 1000 | ○ |
| Example 8 | AlN | 20 | 14.1 | 110 | 170 | 720 | 20°C | OK | ≧ 1000 | ○ |
| Example 9 | AlN | 20 | 28.2 | 110 | 170 | 720 | 20°C | OK | ≧ 1000 | ○ |
| Example 10 | AlN | 20 | 14.1 | 220 | 170 | 610 | 20°C | OK | ≧ 1000 | ○ |
| Example 11 | AlN | 20 | 28.2 | 220 | 170 | 610 | 20°C | OK | ≧ 1000 | ○ |
| Example 12 | AlN | 20 | 14.1 | 110 | 170 | 720 | 15°C | OK | ≧ 1000 | ○ |
| Example 13 | AlN | 20 | 14.1 | 110 | 170 | 720 | 30°C | OK | ≧ 1000 | ○ |
| Example 14 | AlN | 20 | 14.1 | 110 | 170 | 720 | 20°C | OK | ≧ 1000 | ○ |
| Example 15 | AlN | 20 | 14.1 | 110 | 170 | 720 | 40°C | OK | ≧ 1000 | ○ |
| Example 16 | AlN | 20 | 14.1 | 110 | 170 | 720 | 50°C | OK | ≧ 1000 | ○ |
| Example 17 | AlN | 20 | 14.1 | 110 | 340 | 550 | 50°C | OK | ≧ 1000 | ○ |

### Conditions for evaluation:

Removal of the brazing material and the like: Samples were rated OK when no brazing material and the like were found to remain in the visual check and samples with the brazing material and the like remaining were rated NG. As for insulation resistance, the values between circuit patterns and across the circuit board were measured with an insulation resistance meter (Model 8511 of Tsuruga Electric Co., Ltd.) at a voltage of 1,000 V dc and samples showing values of 1,000 MQ and more (at room temperature) were rated satisfactory.

Line linearity: Lines in circuit patterns were visually checked for linearity and evaluated O when they were satisfactorily linear but evaluated X when they undulated.

### [Example 2]

The procedure of Example 1 was repeated except that a 96% grade alumina substrate manufactured by Nikko was substituted for AlN as the ceramic substrate. The alumina substrate which was initially white turned to have a very pale grayish hue after removing the residual brazing material and the like but its electrical characteristics were not at all affected. The conditions for preparing the sample of Example 2 and the results of evaluation of the circuit board produced are shown in Table 1.

### [Example 3]

A sample was prepared and evaluated as in Example 1 except that the thickness of the brazing material and the like was changed to 10 microns. The conditions for preparing the sample of Example 3 and the results of evaluation of the circuit board produced are shown in Table 1.

### [Example 4]

A sample was prepared and evaluated as in Example 1 except that the metal ingredients in the brazing material were of a 71Ag-27Cu-2Ti (wt%) system. The conditions for preparing the sample of Example 4 and the results of evaluation of the circuit board produced are shown in Table 1.

### [Example 5]

A sample was prepared and evaluated as in Example 4 except that the brazing material was in foil form, the brazing material and the like were 50 microns thick and the time of treatment was 80 minutes. The conditions for preparing the sample of Example 5 and the results of evaluation of the circuit board produced are shown in Table 1.

### [Example 6]

A sample was prepared and evaluated as in Example 1 except that the metal ingredients in the brazing material were of an 81Ag-17Cu-1.5Ti-0.5TiO₂ (wt%) system. The conditions for preparing the sample of Example 6 and the results of evaluation of the circuit board produced are shown in Table 1.

### [Example 7]

A sample was prepared and evaluated as in Example 2 except that the metal ingredients in the brazing material were of an 81Ag-17Cu-1.5Ti-0.5 TiO₂ (wt%) system. The conditions for preparing the sample of Example 7 and the results of evaluation of the circuit board produced are shown in Table 1.

### [Example 8]

A sample was prepared and evaluated as in Example 1 except that the metal ingredients in the brazing material were of a 91Ag-7Cu-1.5Ti-0.5TiO₂ (wt%) system. The conditions for preparing the sample of Example 8 and the results of evaluation of the circuit board produced are shown in Table 1.

### [Examples 9, 10 and 11]

Samples were prepared and evaluated as in Example 8 except that the liquid chemical had the compositions shown in Table 1. The conditions for preparing the samples of Examples 9-11 and the results of evaluation of the circuit boards produced are shown in Table 1.

### [Examples 12 and 13]

Samples were prepared and evaluated as in Example 8 except that the liquid chemical had the temperatures shown in Table 1. The conditions for preparing the samples of Examples 12 and 13 and the results of evaluation of the circuit boards produced are shown in Table 1.

### [Example 14]

A sample was prepared and evaluated as in Example 8 except that the liquid chemical was sprayed onto the sample. The conditions for preparing the sample of Example 14 and the results of evaluation of the circuit board produced are shown in Table 1.

### [Example 15]

A sample was prepared and evaluated as in Example 8 except that the liquid chemical had a temperature of 40 °C. The conditions for preparing the sample of Example 15 and the results of evaluation of the circuit board produced are shown in Table 1, from which one can see that the sample of Example 15 had the desired characteristics with successful dissolution of the brazing material and the like. It should, however, be noted that the liquid chemical bubbled actively.

### [Example 16]

A sample was prepared and evaluated as in Example 8 except that the liquid chemical had a temperature of 50 °C. The conditions for preparing the sample of Example 16 and the results of evaluation of the circuit board produced are shown in Table 1, from which one can see that the sample of Example 16 had the desired characteristics with successful dissolution of the brazing material and the like. On the other hand, the liquid chemical bubbled so vigorously as to present the danger of bumping and from the handling viewpoint, industrial use of the liquid chemical was difficult. There was also a visible color change in the surface of the Cu sheet.

### [Example 17]

A sample was prepared and evaluated as in Example 8 except that the liquid chemical had a temperature of 50 °C and that the volume of aqueous hydrogen peroxide was 340 ml/L. The conditions for preparing the sample of Example 17 and the results of evaluation of the circuit board produced are shown in Table 1, from which one can see that the sample of Example 17 had the desired characteristics with successful dissolution of the brazing material and the like. On the other hand; the liquid chemical bubbled so vigorously as to present a high risk of bumping and from the handling viewpoint, industrial use of the liquid chemical was difficult.

### [Comparative Examples 1, 2, 3 and 4]

Samples were prepared and evaluated as in Example 8 except that the composition of the liquid chemical was changed as shown in Table 2 and that it had a temperature of 40 °C. The conditions for preparing the samples of Comparative Examples 1-4 and the results of evaluation of the circuit boards produced are shown in Table 2. The brazing material and the like were not removed in the samples of Comparative Examples 1 and 2 whereas the brazing material and the like dissolved in the samples of Comparative Examples 3 and 4 but lines in the circuit patterns undulated.

**Table 2**

| Conditions for sample preparation and the results of evaluation | | | | | | | | | | |
|---|---|---|---|---|---|---|---|---|---|---|
| Comparative Example No. | ceramic substrate | thickness of brazing material and the like (µm) | composition of liquid chemical and temperature at the time of start of treatment | | | | | removal of brazing material and the like | electrical resistance (MΩ) | line linearity |
| | | | hydrogen fluoride (%) | ammonium fluoride (%) | nitric acid (%) | aqueous hydrogen peroxide (%) | temperature (°C) | | | |
| 1 | AlN | 20 | 10 | - | - | - | 40 | NG | <100 | ○ |
| 2 | AlN | 20 | - | 10 | - | - | 40 | NG | <100 | ○ |
| 3 | AlN | 20 | 10 | - | 20 | 5 | 40 | OK | ≧ 1000 | × |
| 4 | AlN | 20 | - | 10 | 20 | 5 | 40 | OK | ≧1000 | × |

| | | | | | | | | | | |
|---|---|---|---|---|---|---|---|---|---|---|
| * The conditions for evaluation were the same as described in connection with the data shown in Table 1. | | | | | | | | | | |

According to the present invention, the metal sheet, ceramic substrate, as well as the production and liquid waste treatment equipment are prevented from corroding and the unwanted brazing material and the like that remain on the metal sheet after etching are selectively dissolved away in an efficient manner, thereby enabling the production of a ceramic circuit board on which are formed highly precise circuit patterns optimum for the fabrication of power modules. The thus produced ceramic circuit board can be used to fabricate a desired module.

As a further advantage, the liquid waste formed after dissolving the unwanted brazing material and the like can be treated to reclaim or recover the chelating reagent and this contributes to significant reduction in the production cost.

## Claims

1. A process for producing a ceramic circuit board comprising the steps of joining a metal sheet to at least one side of a ceramic substrate with the intermediary of a brazing material, etching said metal sheet to a circuit pattern and then applying a liquid chemical containing a chelating reagent and aqueous hydrogen peroxide or a liquid chemical containing a chelating reagent, aqueous hydrogen peroxide and an alkali to remove said brazing material and the reaction product between the brazing material and the ceramic substrate that have become exposed as the result of said etching.

2. The process according to claim 1, wherein after removing said brazing material and the reaction product between the brazing material and the ceramic substrate, a Ni plating or a Ni alloy plating is applied to said metal sheet.

3. The process according to claim 1 or 2, wherein said chelating reagent is at least one compound selected from the group consisting of EDTA, NTA, CyDTA, DTPA, TTHA, GEDTA and salts thereof.

4. The process according to any one of claims 1-3, wherein said alkali is at least one compound selected from the group consisting of ammonia, NaOH and KOH.

5. The process according to any one of claims 1-4, wherein said brazing material is one which contains Ag and an active metallic element.

6. The process according to any one of claims 1-5, wherein said ceramic substrate is one which comprises Al₂O₃, AlN or Si₃N₄ as a main component.

7. The process according to any one of claims 1-6, wherein said liquid chemical has a temperature of 40 °C or less when said brazing material and the reaction product between the brazing material and the ceramic substrate are being removed.

8. A ceramic circuit board for use in making a power module which is produced by the process according to any one of claims 1-7.

9. A module using a ceramic circuit board produced by the process according to any one of claims 1-7.

## Patentansprüche

1. Verfahren zur Herstellung einer Keramikschaltplatte, mit den Schritten des Verbindens einer Metallschicht bzw.- folie mit mindestens einer Seite eines Keramiksubstrats, wobei sich dazwischen ein Hartlötmaterial befindet, Ätzen der Metallschicht zu einem Schaltungsmuster und anschließend Aufbringen einer flüssigen Chemikalie, die ein komplexierendes Reagens und wässerigen Wasserstoffperoxid enthält, oder einer flüssigen Chemikalie, die ein komplexierendes Reagens, wässerigen Wasserstoffperoxid und ein Alkali enthält, um das Hartlötmaterial und das Reaktionsprodukt zwischen dem Hartlötmaterial und dem Keramiksubstrat, die als Resultat des Ätzens freigelegt worden waren, zu entfernen.

2. Verfahren nach Anspruch 1, worin nach der Entfernung des Hartlötmaterials und des Reaktionsprodukts zwischen dem Hartlötmaterial und dem Keramiksubstrat eine Ni-Plattierung oder eine Ni-Legierungs-Plattierung auf die Metallschicht aufgebracht wird.

3. Verfahren nach Anspruch 1 oder 2, worin das komplexierende Reagens mindestens eine Verbindung ist, die aus der Gruppe ausgewählt ist, bestehend aus EDTA, NTA, CyDTA, DTPA, TTHA, GEDTA und Salzen davon.

4. Verfahren nach einem der Ansprüche 1-3, worin das Alkali mindestens eine Verbindung ist, die aus der Gruppe ausgewählt ist, bestehend aus Ammoniak, NaOH und KOH.

5. Verfahren nach einem der Ansprüche 1-4, worin das Hartlötmaterial ein solches ist, welches Ag und ein aktives metallisches Element enthält.

6. Verfahren nach einem der Ansprüche 1-5, worin das Keramiksubstrat ein solches ist, welches Al₂O₃, AlN oder Si₃N₄ als Hauptkomponente enthält.

7. Verfahren nach einem der Ansprüche 1-6, worin die flüssige Chemikalie eine Temperatur von 40°C oder weniger aufweist, wenn das Hartlötmaterial und das Reaktionsprodukt zwischen dem Hartlötmaterial und dem Keramiksubstrat entfernt werden.

8. Keramikschaltplatte zur Verwendung bei der Herstellung eines Leistungsmoduls, welche gemäß dem Verfahren nach einem der Ansprüche 1-7 hergestellt wird.

9. Modul, bei dem eine nach dem Verfahren nach einem der Ansprüche 1-7 hergestellte Keramikschaltplatte verwendet wird.

## Revendications

1. Procédé pour produire une carte de circuit imprimé en céramique comprenant les étapes consistant à joindre une feuille de métal à au moins une face d'un substrat en céramique par l'intermédiaire d'un matériau de brasage, graver ladite feuille de métal en un motif de circuit et ensuite appliquer une substance chimique liquide contenant un réactif chélateur et du peroxyde d'hydrogène aqueux ou une substance chimique liquide contenant un réactif chélateur, du peroxyde d'hydrogène aqueux et un alcali pour éliminer ledit matériau de brasage et le produit de réaction entre le matériau de brasage et le substrat en céramique qui sont devenus exposés en conséquence de ladite gravure.

2. Procédé selon la revendication 1, dans lequel après l'élimination dudit matériau de brasage et du produit de réaction entre le matériau de brasage et le substrat en céramique, un placage de Ni ou un placage d'alliage de Ni est appliqué sur ladite feuille de métal.

3. Procédé selon la revendication 1 ou 2, dans lequel ledit réactif chélateur est au moins un composé choisi dans le groupe constitué de EDTA, NTA, CyDTA, DTPA, TTHA, GEDTA et des sels de ceux-ci.

4. Procédé selon l'une quelconque des revendications 1 à 3, dans lequel ledit alcali est au moins un composé choisi dans le groupe constitué de l'ammoniac, NaOH et KOH.

5. Procédé selon l'une quelconque des revendications 1 à 4, dans lequel ledit matériau de brasage est un matériau qui contient Ag et un élément métallique actif.

6. Procédé selon l'une quelconque des revendications 1 à 5, dans lequel ledit substrat en céramique est un matériau qui comprend Al₂O₃, AIN ou Si₃N₄ en tant que composant principal.

7. Procédé selon l'une quelconque des revendications 1 à 6, dans lequel ladite substance chimique liquide a une température de 40°C ou moins lorsque ledit matériau de brasage et le produit de réaction entre le matériau de brasage et le substrat en céramique sont éliminés.

8. Carte de circuit imprimé en céramique pour utilisation dans la fabrication d'un bloc de puissance qui est produit par le procédé selon l'une quelconque des revendications 1 à 7.

9. Module utilisant une carte de circuit imprimé produit par le procédé selon l'une quelconque des revendications 1 à 7.
